# EUROPEAN PATENT APPLICATION

(11) **EP 2 218 806 A1**
(43) Date of publication of application: **18.08.2010**
(21) Application number: 08857491.8
(22) Date of filing: 13.11.2008
(51) Int. Cl.: C30B 29/38, C30B 23/06

(54) **ALN CRYSTAL AND METHOD FOR GROWING THE SAME**

(30) Priority: 04.12.2007 JP 2007313359
(71) Applicant: Sumitomo Electric Industries, Ltd., Chuo-ku Osaka-shi Osaka 541-0041 (JP)
(72) Inventor: SATOH, Issei, Itami-shi Hyogo 664-0016 (JP); MIZUHARA, Naho, Itami-shi Hyogo 664-0016 (JP); TANIZAKI, Keisuke, Itami-shi Hyogo 664-0016 (JP); MIYANAGA, Michimasa, Itami-shi Hyogo 664-0016 (JP); NAKAHATA, Hideaki, Itami-shi Hyogo 664-0016 (JP)
(74) Representative: Grünecker, Kinkeldey, Stockmair & Schwanhäusser Anwaltssozietät
(86) International application number: PCT/JP2008/070648
(87) International publication number: WO 2009/072378

(57) **Abstract**

The present invention makes available an AlN crystal growth method enabling large-area, thick AlN crystal to be stably grown. An AlN crystal growth method of the present invention is provided with a step of preparing an SiC substrate (4) having a major face (4*m*) with a 0 cm⁻² density of micropipes (4*mp*) having tubal diameters of down to 1000 µm, and a not greater than 0.1 cm⁻² density of micropipes (4*mp*) having tubal diameters of between 100 µm and less than 1000 µm; and a step of growing AlN crystal (5) onto the major face (4*m*) by vapor-phase deposition.

## Description

### Technical Field

The present invention relates to AlN crystal, and to methods of growing the crystal, used in applications including wafers for semiconductor devices, such as optoelectronic devices, other electronic devices, and semiconductor sensors. More particularly, the invention relates to AlN crystal growth methods employing SiC substrates.

### Background Art

AlN crystal finds extraordinary utility as a material for forming semiconductor devices, such as optoelectronic devices, other electronic devices, and semiconductor sensors. Methods for producing the AlN crystal include, to cite one class, vapor-phase deposition methods such as sublimation method.

In order to grow bulk AlN crystal by vapor-phase deposition, large-diameter starting substrates are necessary. AlN crystal done by sublimation method employing a variety of different starting substrates has been proposed. (Reference is made, for example, to Japanese Unexamined Pat. App. Pub. No. 10-53495 (Patent Document 1), the specification for U.S. Pat. No. 6,045,612 (Patent Document 2), the specification for U.S. Pat. No. 6,296,956 (Patent Document 3), and the specification for U.S. Patent No. 6,770,135 (Patent Document 4).) Nevertheless, because achieving large-scale AlN wafers has in actuality proven to be difficult, nonnative starting substrates, whose type and fractions of atomic elements differ from those constituting the AlN crystal that is grown, are employed. Wafers of a material such as SiC whose lattice mismatch with AlN crystal is slight are preferably employed as such starting substrates.
***Patent Document 1:*** Japanese Unexamined Pat. App. Pub. No. 10-53495
***Patent Document 2:*** Specification for U.S. Pat. No. 6,045,612
***Patent Document 3:*** Specification for U.S. Pat. No. 6,296,956
***Patent Document 4:*** Specification for U.S. Pat. No. 6,770,135

### Disclosure of Invention

### Problem Invention Is to Solve

Growing AlN crystal onto an SiC substrate by sublimation method or other vapor-phase technique, however, in some cases brings the temperature at which the AlN crystal is grown to near or above the temperature at which SiC sublimes. That causes micropipes present in the SiC substrate to grow larger, which is deleterious to the SiC substrate. The result is prohibitive of stably growing AlN crystal thick. SiC substrates in which such micropipes are reduced or nonexistent have been under development in recent years.

Therein, an object of the present invention is to make available an AlN crystal growth method that, utilizing an SiC substrate in which the micropipe density is low or zero and qualitative loss is minimal, enables large-diameter, thick AlN crystal to be stably grown.

### Means for Resolving the Problem

The present invention is an AlN crystal growth method provided with: a step of preparing an SiC substrate having a major face with a 0 cm⁻² density of micropipes having tubal diameters of down to 1000 µm, and a not greater than 0.1 cm⁻² density of micropipes having tubal diameters of between 100 µm and less than 1000 µm; and a step of growing AlN crystal onto the major face by vapor-phase deposition.

With an AlN crystal growth method involving the present invention, it is possible to have it that in the major face the 0 cm⁻² density is of micropipes having tubal diameters down to 100 µm, and that there is a not greater than 1.0 cm⁻² density of micropipes having tubal diameters of between 10 µm and less than 100 µm. It is further possible to have it that in the major face the 0 cm⁻² density is of micropipes having tubal diameters down to 10 µm, and that there is a not greater than 1.0 cm⁻² density of micropipes having tubal diameters of between 1 µm and less than 10 µm. It is still further possible to have it that in the major face the 0 cm⁻² density is of micropipes having tubal diameters down to 1 µm, and that there is a not greater than 1.0 cm⁻² density of micropipes having tubal diameters of between 0.1 µm and less than 1 µm. Herein, it is possible to have the major face be the C-atom side.

The present invention is also AlN crystal obtained by the growth method set forth above, the AlN crystal having a through-hole density along the AlN crystal major surface of not greater than 1.0 cm⁻².

### Effects of the Invention

In accordance with the present invention, made available is an AlN crystal growth method that, utilizing an SiC substrate in which the micropipe density is low or zero and qualitative loss is minimal, enables large-diameter, thick AlN crystal to be stably grown.

### Brief Description of Drawings

Fig. 1A is an outline plan view illustrating one mode of embodying an SiC substrate utilized in an AlN wafer growth method involving the present invention.
Fig. 1B, an outline sectional view through IB-IB in Fig. 1A, is a diagram summarily illustrating the one mode of embodying an SiC substrate utilized in an AlN wafer growth method involving the present invention.
Fig. 2 is an outline sectional view illustrating one mode of embodying crystal obtained by an AlN crystal growth method of the present invention.
Fig. 3 is an outline sectional view for illustrating one example of an AlN crystal growth method of the present invention.

### Legend

- 2:: AlN source material
- 4:: SiC substrate
- 4*m*:: major face
- 4*mp:*: micropipe
- 5:: AlN crystal
- 5*h:*: holes
- 5*hs*:: buried hole
- 5*ht:*: through-hole
- 5*s:*: crystal major surface
- 10:: sublimation furnace
- 11:: reaction vessel
- 11*a:*: N₂ gas introduction port
- 11*c*:: N₂ gas exhaust port
- 12:: crucible
- 12*c*:: ventilation port
- 12*p*:: crucible lid
- 12*q*:: crucible body
- 13:: heating component
- 14:: RF power heating coil
- 15:: radiation thermometer
- *D*:: tubal diameter

### Best Mode for Carrying Out the Invention

Below, modes of embodying the present invention will be described. It is to be noted that, in discussing the drawings, where identical or equivalent elements are labeled with identical reference marks, redundant explanations will be omitted. Furthermore, dimensional proportions in the drawings do not necessarily agree with what is described.

### Embodiment Mode 1

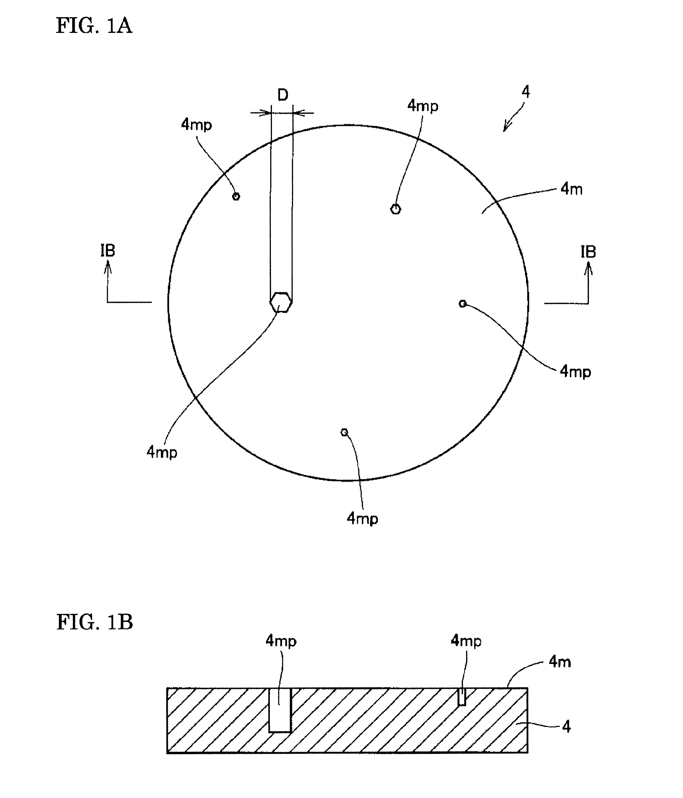

Reference is made to Figs. 1A and 1B. One mode of embodying an AlN crystal growth method involving the present invention is provided with the following steps. Fig. 1A is an outline plan view illustrating one mode of embodying an SiC substrate utilized in the AlN wafer growth method involving the present invention, while Fig. 1B is an outline sectional view through IB-IB in Fig. 1A.
(1) A step of preparing an SiC substrate 4 having a major face 4*m* with a 0 cm⁻² density of micropipes 4*mp* having tubal diameters *D* of down to 1000 µm, and a not greater than 0.1 cm⁻² density of micropipes 4*mp* having tubal diameters *D* of between 100 µm and less than 1000 µm.
(2) A step of growing AlN crystal 5 onto the major face 4m by vapor-phase deposition.

It should be noted that in the present invention, micropipes are crystal defects-specifically, pipelike holes within a crystal.
In the major face 4*m* there is a 0 cm⁻² density of micropipes 4*mp* having tubal diameters *D* of down to 1000 µm, and a low (not greater than 0.1 cm⁻²) density of micropipes 4*mp* having a tubal diameter *D* of between 100 µm and less than 1000 µm. Growing AlN crystal 5 onto the thus-conditioned major face 4m of the SiC substrate 4 makes it possible to stably grow large-diameter, thick AlN crystal.

Reference is made to Figs. 1A and 1B. An AlN crystal growth method in the present embodying mode is provided with a step of preparing an SiC substrate 4 having a major face 4m with a 0 cm⁻² density of micropipes 4*mp* having tubal diameters *D* of down to 1000 µm, and a not greater than 0.1 cm⁻² density of micropipes 4*mp* having tubal diameters *D* of between 100 µm and less than 1000 µm.

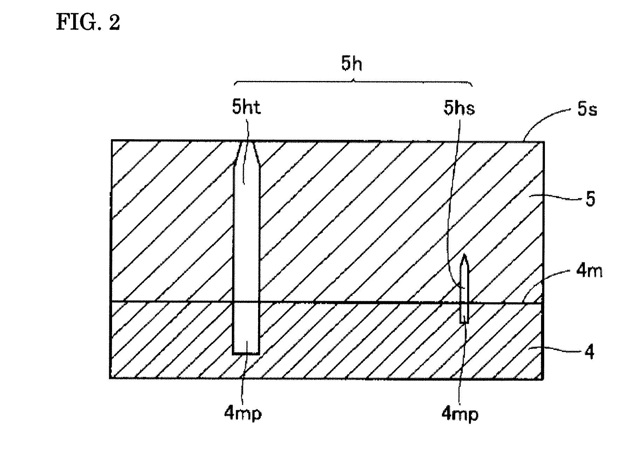

Reference is made to Fig. 2. In some cases an SiC substrate 4 involving the present invention will contain micropipes 4*mp.* When such micropipes 4mp appear on the major face 4*m* of an SiC substrate 4, though AlN crystal 5 is grown onto the major face 4*m*, the AlN crystal 5 will not grow directly above the micropipes 4*mp,* where instead holes 5*h* form. By the AlN crystal 5 being grown thick, a number of these holes 5*h* become buried by the AlN crystal 5, turning into buried holes 5*hs,* which do not appear in the crystal major surface 5*s*. A certain number of the holes 5*h*, however, do not, despite the AlN crystal 5 being grown thick, become buried by the AlN crystal 5, and turn into through-holes 5*ht* that, penetrating the AlN crystal 5 to the crystal major surface 5s from the interface between the AlN crystal 5 and the SiC substrate 4, appear in the crystal major surface 5s.

When AlN crystal 5 is grown onto the major face 4m of an SiC substrate 4, whether or not the AlN crystal 5 will bury holes 5*h* directly above micropipes *4mp* in the SiC substrate-that is, whether through-holes 5*ht* will or will not appear in the crystal major surface 5s of the grown AlN crystal 5-differs depending on factors including the tubal diameter *D* and density of the micropipes 4*mp,* and the growth thickness of the AlN crystal 5. The likelihood that the AlN crystal 5 will bury holes 5*h* directly above micropipes 4*mp* in an SiC substrate 4 grows greater the lesser is the tubal diameter *D* and density of the micropipes 4*mp* and the greater is the thickness to which the AlN crystal 5 is grown. Herein, inasmuch as SiC substrates have a hexagonal crystal-system structure, the micropipes 4*mp* in general will be of hexagonal form in cross-section through the pipes. Accordingly, the tubal diameter *D* of the micropipes 4*mp* is defined as the average of the distances between opposing angles therein.

On account of the foregoing considerations, in the major face 4m of an SiC substrate 4 utilized in a method of growing AlN crystal in the present embodying mode, there is a 0 cm⁻² density of micropipes 4*mp* having tubal diameters *D* of down to 1000 µm, while there is a not greater than 0.1 cm⁻² density of micropipes 4*mp* having tubal diameters *D* of between 100 µm and less than 1000 µm. Growing AlN crystal 5 to a thickness of at least 1 mm onto a thus-conditioned major face 4*m* of an SiC substrate 4 makes it possible to bury, with the AlN crystal 5, holes 5*h* forming directly above the micropipes 4*mp* in the SiC substrate 4, enabling large-area AlN crystal 5 of considerable thickness to be stably grown. Onto a major face 4*m* in which micropipes 4*mp* having tubal diameters of 1000 µm or greater are present, even if AlN crystal 5 is grown to a thickness of 1 mm or greater, burying, with the AlN crystal 5, holes 5*h* forming directly above the micropipes 4*mp* is not possible. Herein, x-ray topography can be used to characterize the density of micropipes having tubal diameters of down to 1000 µm, as well as the density of micropipes having tubal diameters of between 100 µm and less than 1000 µm.

Reference is further made to Fig. 2. An AlN crystal growth method in the present embodying mode is provided with a step of growing AlN crystal onto the above-described major face by vapor-phase deposition.

Herein, "vapor-phase deposition" means a method of growing crystal (AlN crystal) onto a substrate (an SiC substrate) from either a source material that is in a vapor-phase state or a source material that is put into a vapor-phase state, with sublimation method including vapor-phase epitaxy processes such as HVPE (hydride vapor-phase epitaxy). In growing the AlN crystal, from the viewpoint of using simple, convenient manufacturing equipment to grow high quality crystal, sublimation method is often employed. In the following, a method of growing AlN crystal onto an SiC substrate by sublimation method will be described.

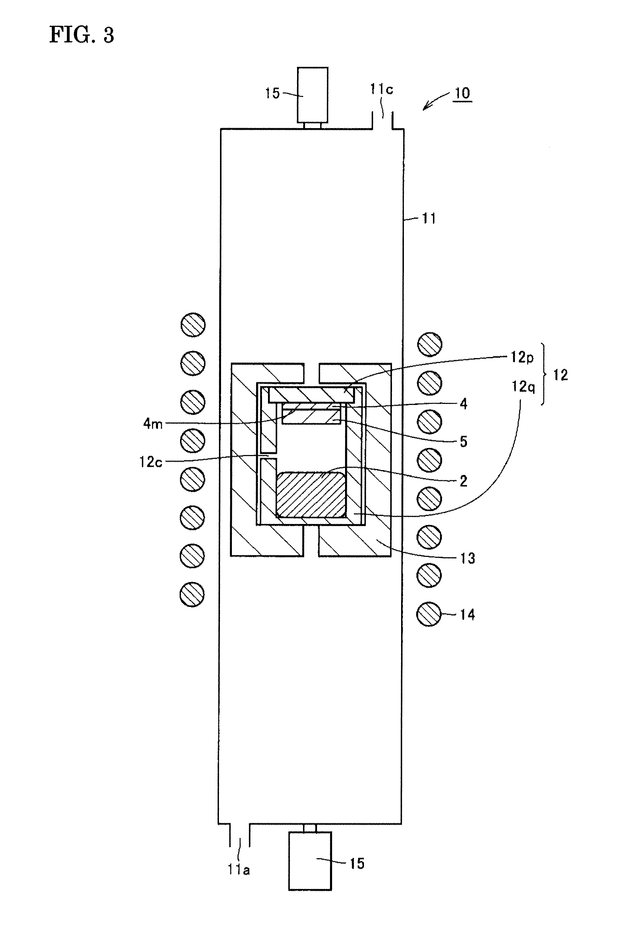

Reference is made to Fig. 3. "Sublimation method" utilized in the present embodying mode means a process whereby an AlN source material 2 is sublimed and then re-solidified onto an SiC substrate 4 to yield an AlN crystal 5. A vertical sublimation furnace 10 with an RF-power heating system, as represented in Fig. 3, is for example employed in the crystal growth by the sublimation process. The vertical sublimation furnace 10, in the central portion of its reaction vessel 11, is equipped with a crucible 12, made of tungsten carbide, having a ventilation port 12c, while surrounding the crucible 12 in such a manner as to ensure ventilation from the inside of the crucible 12 to its exterior, a heating component 13, made of carbon, is furnished. The crucible 12 is constituted by a crucible body 12*q* and a crucible lid 12*p*. In addition, the reaction vessel 11, in the central portion along its outer side, is equipped with an RF-power heating coil 14 for heating the heating component 13. The reaction vessel 11 at its ends is furthermore furnished with an N₂-gas introduction port 11*a* and an N₂-gas exhaust port 11c, to allow N₂ gas to be flowed to the exterior of the crucible 12 in the reaction vessel 11, and with a radiation thermometer 15 for measuring the temperature of the top and bottom sides of the crucible 12.

In the AlN crystal growth method of the present embodying mode, the step of growing AlN crystal 5 onto the major face 4m of the SiC substrate 4 is carried out as follows (with reference exemplarily to Fig. 3), utilizing the above-described vertical sublimation furnace 10.

To begin with, the AlN source material 2 is stowed inside the crucible body 12*q*, and over the inner side of the crucible lid 12p an aforedescribed SiC substrate 4 is disposed so that its major face 4m opposes the AlN source material 2. Next, while N₂ gas is flowed into the reaction vessel 11, the temperature within the crucible 12 is ramped up by employing the RF heating coil 14 to heat the heating component 13. AlN crystal 5 is grown by maintaining the temperature at the AlN source material 2 end of the crucible 12 higher than the temperature at the SiC substrate 4 end, to sublime AlN from the AlN source material 2 and cause the AlN to re-solidify onto the major face 4m of the SiC substrate 4.

During the growth of the AlN crystal 5, the temperature of the crucible 12 at the AlN source material 2 end (hereinafter also referred to as the sublimation temperature) is put at some 1600°C to 2300°C, while the temperature of the crucible 12 at the SiC substrate 4 end (hereinafter also referred to as the crystal-growth temperature) is made some 10°C to 200°C lower than the temperature on the AlN source material 2 end (the sublimation temperature). Large-area, thick AlN crystal 5 is thereby stably produced. Further, also during the crystal growth, by continuously flowing N₂ gas along the outer side of the crucible 12 within the reaction vessel 11 in such a way that the gas partial pressure will be some 101.3 hPa to 1013 hPa, in-mixing of impurities into the AlN crystal 5 can be reduced.

It should be noted while the crucible 12 interior is heating up, the temperature of the crucible 12 other than at the AlN source material 2 end is made higher than the temperature of that portion. This makes it possible to rid the crucible 12 interior of impurities through the ventilation port 12c, and accordingly makes it possible to further reduce the in-mixing of impurities into the AlN crystal 5.

The major face 4*m* of an SiC substrate 4 utilized in the AlN crystal growth method of the present embodying mode preferably has a 0 cm⁻² density of micropipes 4*mp* having tubal diameters *D* of down to 100 µm, while having a not greater than 1.0 cm⁻² density of micropipes 4*mp* having tubal diameters *D* between 10 µm and less than 100 µm. Growing AlN crystal 5 to a thickness of at least 1 mm onto a thus-conditioned major face 4*m* of an SiC substrate 4 makes it possible to bury, with the AlN crystal 5, holes 5*h* forming directly above the micropipes 4*mp* in the SiC substrate 4, further enabling large-area AlN crystal of considerable thickness to be stably grown. Herein, x-ray topography can be used to characterize the density of micropipes having tubal diameters of down to 100 µm, as well as the density of micropipes having tubal diameters of between 10 µm and less than 100 µm.

The major face 4*m* of an SiC substrate 4 utilized in the AlN crystal growth method of the present embodying mode more preferably has a 0 cm⁻² density of micropipes 4*mp* having tubal diameters *D* of down to 10 µm, while having a not greater than 1.0 cm⁻² density of micropipes 4*mp* having tubal diameters *D* between 1 µm and less than 10 µm. Growing AlN crystal 5 to a thickness of at least 1 mm onto a thus-conditioned major face 4*m* of an SiC substrate 4 makes it possible to bury, with the AlN crystal 5, holes 5*h* forming directly above the micropipes 4*mp* in the SiC substrate 4, further enabling large-area AlN crystal of considerable thickness to be stably grown. Herein, x-ray topography can be used to characterize the density of micropipes having tubal diameters of down to 10 µm, as well as the density of micropipes having tubal diameters of between 1 µm and less than 10 µm.

The major face 4m of an SiC substrate 4 utilized in the AlN crystal growth method of the present embodying mode still more preferably has a 0 cm⁻² density of micropipes 4*mp* having tubal diameters *D* of down to 1 µm, while having a not greater than 1.0 cm⁻² density of micropipes 4*mp* having tubal diameters *D* of between 0.1 µm and less than 1 µm. Growing AlN crystal 5 to a thickness of at least 1 mm onto a thus-conditioned major face 4m of an SiC substrate 4 makes it possible to bury, with the AlN crystal 5, holes 5*h* forming directly above the micropipes 4*mp* in the SiC substrate 4, further enabling large-area AlN crystal of considerable thickness to be stably grown. Herein, x-ray topography can be used to characterize the density of micropipes having tubal diameters of down to 1 µm. And a scanning electron microscope (SEM) can be employed to characterize the density of micropipes having tubal diameters of between 0.1 µm and less than 1 µm.

In the AIN crystal growth method of the present embodying mode, the major face of the SiC substrate preferably is the C-atom side. Compared with the instance in which AlN crystal is grown onto the Si-atom side of the SiC substrate as its major face, the crystal major surface will more readily turn out flat if the AlN crystal is grown onto the C-atom side of the SiC substrate as its major face, because the AlN crystal will grow spreading two-dimensionally over the C-atom side.

### Embodiment Mode 2

One mode of embodying AlN crystal involving the present invention is AlN crystal 5 obtained by the growth method of Embodying Mode 1, wherein the density of through-holes 5*ht* in the crystal major surface 5*s* (cf. Fig. 2) is not greater than 1.0 cm⁻². Growing AlN crystal to a thickness of at least 1 mm by the AlN crystal growth method of Embodying Mode 1 yields AlN crystal whose through-hole 5*ht* density in the crystal major surface 5s is not greater than 1.0 cm⁻².

In the AlN crystal growth method of Embodying Mode 1, the AlN crystal is grown onto SiC substrates in which micropipes having tubal diameters within a certain range are present, without undergoing almost any influence from the presence of micropipes of tubal diameters that are no more than 1/10 of that range. That is why utilizing SiC substrates having a major face with a 0 cm⁻² density of micropipes having tubal diameters of down to 1000 µm and with a not greater than 0.1 cm⁻² density of micropipes having tubal diameters of between 100 µm and less than 1000 µm, or SiC substrates having a major face with a 0 cm⁻² density of micropipes having tubal diameters of down to 100 µm and with a not greater than 1.0 cm⁻² density of micropipes having tubal diameters of between 10 µm and less than 100 µm, or SiC substrates having a major face with a 0 cm⁻² density of micropipes having tubal diameters of down to 10 µm and a not greater than 1.0 cm⁻² density of micropipes having tubal diameters of between 1 µm and less than 10 um, or SiC substrates having a major face with a 0 cm⁻² density of micropipes having tubal diameters of down to 1 µm and a not greater than 1.0 cm⁻² density of micropipes having tubal diameters of between 0.1 µm and less than 1 µm will, with any such substrate, yield AlN crystal in which the density of through-holes in the crystal major surface is not greater than 1.0 cm⁻², or else is zero.

It will be appreciated that with regard to the method of growing the AlN crystal, while in the present embodying mode the description was made based on sublimation method, application in other vapor-phase deposition processes such as HVPE (hydride vapor-phase epitaxy) is of course possible.

### Embodiments

### Embodiments A

### 1. SiC Substrate Preparation

From a number of commercially available, 1-in (25.4-mm) diameter × 400-µm thick 4H-SiC substrates (mfd. by Cree, Inc., by Sixon Ltd., etc.), a plurality of SiC substrates (Comparative Examples AR1 to AR4, and substrates for Embodiments A1 to A8), having in the Si-atom side as the major face micropipes of tubal diameters D as indicated in Table I, at densities as set forth in Table I, was selected. It should be understood that in Table I, "-" indicates that the item was indeterminate.

### 2. AlN Crystal Growth

With reference to Fig. 3, an AlN sinter as a source material (AlN source material 2) was placed into the bottom of the tungsten-carbide crucible body 12*q*. Following that, each of the 4H-SiC substrates 4, selected as just described, was placed onto the inner side of the tungsten-carbide crucible lid 12*p* so that the Si-atom side as the major surface 4m would oppose the AlN sinter (AlN source material 2).

Next, while N₂ gas was flowed into the reaction vessel 11, the RF heating coil 14 was employed to ramp up the temperature within the crucible 12. While the inside of the crucible 12 was heating up, the temperature on the crucible lid 12*p* end of the crucible 12 was made higher than the temperature on the AlN source material 2 end, to etch and thereby clean the crucible lid 12*p* and the Si-atom side (major face 4*m*) of the SiC substrate 4 during the ramp-up, and at the same time eliminate through the ventilation port 12c impurities given off from the interior of the crucible 12 as it heated up.

Next, the temperature on the AlN source material 2 end (sublimation temperature) of the crucible 12 was brought to 2100°C, and the temperature on the 4H-SiC substrate 4 end (crystal-growth temperature) was brought to 2000°C to sublime AlN from the AlN sinter (AlN source material 2) and grow AlN crystal 5 by causing the AlN to re-solidify onto the Si-atom side (major face 4*m*) of the 4H-SiC substrate 4 in the upper part of the crucible 12. Also during growth of the AlN crystal 5, N₂ gas was continuously flowed over the outside of the crucible 12 within the reaction vessel 11, with the N₂ gas introduction volume and N₂ gas exhaust volume being controlled so that the gas partial pressure along the outside of the crucible 12 within the reaction vessel 11 would be some 101.3 hPa to 1013 hPa. The AlN crystal 5 was grown 15 hours under the crystal-growth conditions just described, after which it was cooled down to room temperature (25°C) and taken off the crucible lid 12*p*, whereat AlN crystal 5 of approximately 1 mm thickness had been grown onto the Si-atom side (major face 4*m*) of the 4H-SiC substrate 4. In this way, AlN crystal of approximately 1 mm thickness was grown onto the Si-atom side, as the major face, of the 4H-SiC substrates of Embodiments A1 to A8 and Comparative Examples AR1 to AR4.

The through-hole density in the crystal major surface of the thus-obtained AlN crystal of Embodiments A1 to A8 and Comparative Examples AR1 to AR4 was calculated by observation under a light microscope. The results are tabulated in Table I.

Table I

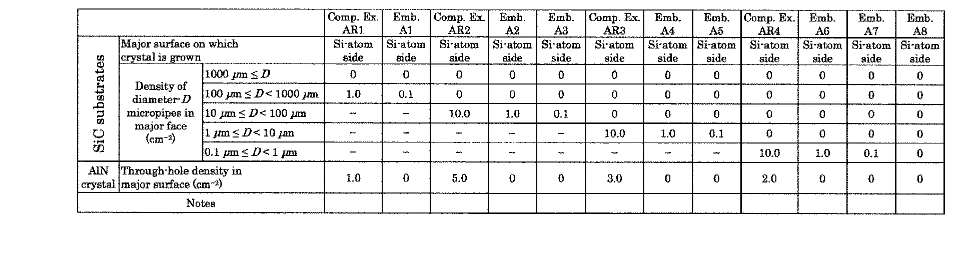

As indicated by Embodiment A1, the threading density in the crystal front side of AlN crystal grown onto an Si-atom side (major face) with a 0 cm⁻² density of micropipes having tubal diameters of down to 1000 µm and a 0.1 cm⁻² density of micropipes having tubal diameters of between 100 µm and less than 1000 µm was 0 cm⁻². And as indicated by Embodiments A2 and A3, the threading density in the crystal front side of AlN crystal grown onto an Si-atom side (major face) with a 0 cm⁻² density of micropipes having tubal diameters of down to 100 µm and a not greater than 1.0 cm⁻² density of micropipes having tubal diameters of between 10 µm and less than 100 µm was 0 cm⁻². Further, as indicated by Embodiments A4 and A5, the threading density in the crystal front side of AlN crystal grown onto an Si-atom side (major face) with a 0 cm⁻² density of micropipes having tubal diameters of down to 10 µm and a not greater than 1.0 cm⁻² density of micropipes having tubal diameters of between 1 µm and less than 10 µm was 0 cm⁻². Still further, as indicated by Embodiments A6 to A8, the threading density in the crystal front side of AlN crystal grown onto an Si-atom side (major face) with a 0 cm⁻² density of micropipes having tubal diameters of down to 1 µm and a not greater than 1.0 cm⁻² density of micropipes having tubal diameters of between 0.1 µm and less than 1 µm was 0 cm⁻². It was thus possible to stably grow AlN crystal of 1 in (25.4 mm) diameter and approximately 1 mm thickness.

### Embodiment B

### 1. SiC Substrate Preparation

From a number of commercially available, 1-in (25.4 mm) diameter × 400-µm thick 4H-SiC substrates (mfd. by Cree, Inc., by Sixon Ltd., etc.), a plurality of SiC substrates (Comparative Examples BR1 to BR4, and substrates for Embodiments B1 to B8), having in the C-atom side as the major face micropipes of tubal diameters *D* as indicated in Table II, at densities as set forth in Table II, was selected. It should be understood that in Table II, "-" indicates that the item was indeterminate.

### 2. AlN Crystal Growth

Apart from placing each of the 4H-SiC substrates 4, selected as just described, onto the inner side of the tungsten-carbide crucible lid 12*p* so that the C-atom side as the major surface 4m would oppose the AlN sinter (AlN source material 2), in the same manner as in Embodiment A1, AlN crystal of approximately 1 mm thickness was grown onto the C-atom side, as the major face, of the 4H-SiC substrates of Embodiments B1 to B8 and Comparative Examples BR1 to BR4.

The through-hole density in the crystal major surface of the thus-obtained AlN crystal of Embodiments B1 to B8 and Comparative Examples BR1 to BR4 was calculated by observation under a light microscope. The results are tabulated in Table II.

Table II

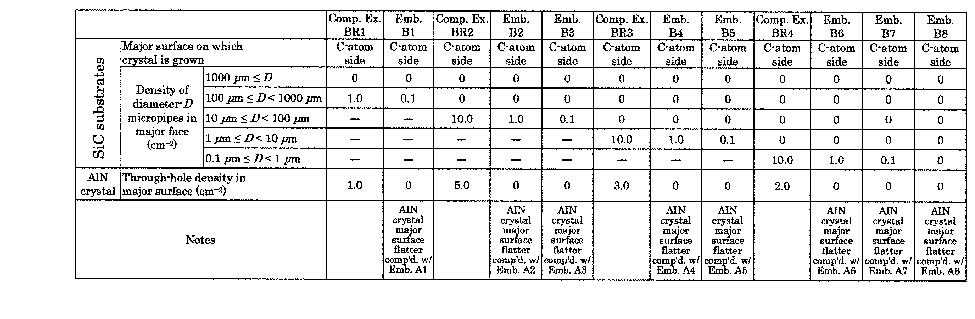

As indicated by Embodiment B1, the threading density in the crystal front side of AlN crystal grown onto a C-atom side (major face) with a 0 cm⁻² density of micropipes having tubal diameters of down to 1000 µm and a 0.1 cm⁻² density of micropipes having tubal diameters of between 100 µm and less than 1000 µm was 0 cm⁻². And as indicated by Embodiments B2 and B3, the threading density in the crystal front side of AlN crystal grown onto a C-atom side (major face) with a 0 cm⁻² density of micropipes having tubal diameters of down to 100 µm and a not greater than 1.0 cm⁻² density of micropipes having tubal diameters of between 10 µm and less than 100 µm was 0 cm⁻². Further, as indicated by Embodiments B4 and B5, the threading density in the crystal front side of AlN crystal grown onto a C-atom side (major face) with a 0 cm⁻² density of micropipes having tubal diameters of down to 10 µm and a not greater than 1.0 cm⁻² density of micropipes having tubal diameters of between 1 µm and less than 10 µm was 0 cm⁻². Still further, as indicated by Embodiments B6 to B8, the threading density in the crystal front side of AlN crystal grown onto a C-atom side (major face) with a 0 cm⁻² density of micropipes having tubal diameters of down to 1 µm and a not greater than 1.0 cm⁻² density of micropipes having tubal diameters of between 0.1 µm and less than 1 µm was 0 cm⁻². It was thus possible to stably grow AlN crystal of 1 in (25.4 mm) diameter and approximately 1 mm thickness.

Furthermore, the major surface of the AlN crystal of Embodiments A1 to A8 and Embodiments B1 to B8 was observed by means of atomic force microscopy (AFM), whereat, as indicated in Table II, the major surface of AlN crystal of Embodiments B1 to B8, which was grown on the C-atom side, was flatter by comparison with the major surface of AlN crystal of each of Embodiments A1 to A8, which was grown on the Si-atom side.

The presently disclosed embodying modes and embodiment examples should in all respects be considered to be illustrative and not limiting. The scope of the present invention is set forth not by the foregoing description but by the scope of the patent claims, and is intended to include meanings equivalent to the scope of the patent claims and all modifications within the scope.

### Industrial Applicability

AlN crystal obtained by a growth method involving the present invention finds broad utilization as substrates in device applications including optical elements such as light-emitting diodes and laser diodes; semiconductor electronic devices such as rectifiers, bipolar transistors, field-effect transistors, and high electron mobility transistors (HEMTs); semiconductor sensors such as emitters, temperature sensors, pressure sensors, radiation sensors, and visible-ultraviolet detector s; and surface acoustic wave (SAW) devices, vibrators, resonators, oscillators, microelectromechanical system (MEMS) parts, and piezoelectric actuators.

## Claims

1. An AlN crystal growth method comprising:
a step of preparing an SiC substrate having a major face with a 0 cm⁻² density of micropipes having tubal diameters of down to 1000 µm, and a not greater than 0.1 cm⁻² density of micropipes having tubal diameters of between 100 µm and less than 1000 µm; and
a step of growing AlN crystal onto the major face by vapor-phase deposition.

2. An AlN crystal growth method as set forth in claim 1, wherein in the major face the 0 cm⁻² density is of micropipes having tubal diameters of down to 100 µm and there is a not greater than 1.0 cm⁻² density of micropipes having tubal diameters of between 10 µm and less than 100 µm.

3. An AlN crystal growth method as set forth in claim 2, wherein in the major face the 0 cm⁻² density is of micropipes having tubal diameters of down to 10 µm, and the not greater than 1.0 cm⁻² density is of micropipes having tubal diameters of between 1 µm and less than 10 µm.

4. An AlN crystal growth method as set forth in claim 3, wherein in the major face the 0 cm⁻² density is of micropipes having tubal diameters of down to 1 µm, and the not greater than 1.0 cm⁻² density is of micropipes having tubal diameters of between 0.1 µm and less than 1 µm.

5. An AlN crystal growth method as set forth in any of claims 1 to 4, wherein said major face is the C-atom side.

6. AlN crystal obtained by a growth method as set forth in any of claims 1 to 5, wherein the AlN crystal has a through-hole density along the AlN crystal major surface of not greater than 1.0 cm⁻².
